**Europäisches Patentamt**

**European Patent Office**

**Office européen des brevets**

(19)

(11) Publication number : **0 314 753 B1**

(12) **EUROPEAN PATENT SPECIFICATION**

(45) Date of publication of patent specification :
30.09.92 Bulletin 92/40

(51) Int. Cl.⁵ : **H03D 9/06, H01P 5/22**

(21) Application number : **88904759.3**

(22) Date of filing : **08.04.88**

(86) International application number :
**PCT/US88/01067**

(87) International publication number :
**WO 88/09088 17.11.88 Gazette 88/25**

(54) SUSPENDED STRIPLINE RAT RACE MIXER WITH SIMPLIFIED I.F. EXTRACTION.

(30) Priority : **07.05.87 US 48104**

(43) Date of publication of application :
**10.05.89 Bulletin 89/19**

(45) Publication of the grant of the patent :
**30.09.92 Bulletin 92/40**

(84) Designated Contracting States :
**DE FR GB IT NL SE**

(56) References cited :
**DE-A- 3 322 559**
**US-A- 3 521 202**

(56) References cited :
**US-A- 3 619 787**
**US-A- 4 008 438**
**US-A- 4 031 472**
**US-A- 4 509 209**

(73) Proprietor : **Martin Marietta Corporation**
**6801 Rockledge Drive**
**Bethesda Maryland 20817 (US)**

(72) Inventor : **PERGANDE, Albert, Norman**
**1706 Oakmont Lane**
**Orlando, FL 32804 (US)**

(74) Representative : **Cotter, Ivan John et al**
**D. YOUNG & CO. 10 Staple Inn**
**London WC1V 7RD (GB)**

EP 0 314 753 B1

Jouve, 18, rue Saint-Denis, 75001 PARIS

## Description

This invention relates generally to suspended stripline rat race mixers useful in the microwave and millimetre wave regions.

Hybrid junction mixers are extensively used in various microwave and millimetre wave balanced-circuit configurations, including balanced mixers, single-sideband modulators, phase and amplitude monopulse comparators, frequency multiplexers, and constant impedance filters.

Several useful forms of hybrid junction mixers are well known, including the hybrid ring mixer or "rat race mixer", and each form is known to be able to be implemented in waveguide, coaxial line, or stripline media.

The basic hybrid ring comprises a closed loop transmission line essentially six quarter wavelengths in length. Four ports (ports 1 to 4) on the ring are spaced 60° apart geometrically, and one quarter wavelength apart electrically. For an ideal hybrid ring, a signal inputted to port 1 divides equally between ports 2 and 4 with a 180° phase difference, whereas a signal inputted to port 3 divides equally between the same ports 2 and 4 with a zero phase difference.

The prior art is replete with variations of the basic hybrid ring. One such prior art disclosure of a suspended stripline rat race mixer is contained in U.S. Patent No. US-A-4 031 472, the construction of which is said to avoid certain defects of the earlier devices. Specifically, US-A-4 031 472 discloses a suspended stripline rat race mixer according to the pre-characterising part of claim 1 hereof.

Others in endeavouring to deal with suspended stripline or other planar transmission lines have found it necessary to use a quarter wave stub for providing radio frequency (RF) and local oscillator (LO) ground, and this had the unfortunate characteristic of limiting bandwidth, and in addition requiring the use of jumper wires for extracting a generated IF signal.

For example, in a certain quartz suspended substrate circuit for radar applications, phase detectors and phase lock loop mixers were often found to occur in awkward and tight spaces. The IF had previously been extracted with a network of capacitors, resistors, and lines.

According to the invention there is provided a suspended stripline rat race mixer comprising:

a ring connected to a radio frequency (RF) input line and a local oscillator (LO) input line each extending radially outwardly of the ring, the ring and the input lines being formed by a conductive layer on one surface of a dielectric substrate;

diode means connecting an outer part of the ring to ground at locations of RF and LO maxima; and

extracting means for extracting an intermediate frequency (IF) signal generated in the ring;

characterised in that the diode means connects the ring to a ground plane formed by a conductive layer on said surface of the substrate, in that the ground plane surrounds the ring entirely except at the input lines, and in that the extracting means is provided at the centre of the ring.

An embodiment of the invention described in detail below comprises a suspended stripline rat race mixer in the form of a ring entirely surrounded by a ground plane located on the same side of a substrate as the ring. Diode means are located on the outer part of the ring, connecting the ring to the ground plane at locations of RF and LO maxima. Means is provided at the centre of the ring, by which the IF generated in the ring is extracted, which means preferably takes the form of a high impedance lead with which a bellows is in contact. This bellows is typically supported by a centre post of a coaxial bulkhead connector associated with the IF circuitry, at which location the extraction of the IF is accomplished. The ground plane surrounding the rat race is ground for all signals in the mixer, that is, for the IF, the RF, and the LO.

As will be seen hereinafter, this enables the IF to be removed without any of the aforementioned complications, such as where the phase detectors or phase lock loop mixers occurred in awkward and tight spaces, and where it was previously necessary to extract the IF with a network of capacitors, resistors, and lines.

It is to be realised that there are other terms for the device referred to herein as a rat race mixer, these being hybrid mixer, hybrid coupler mixer, ring mixer, and 180° coupler mixer.

The suspended stripline rat race mixer embodying the invention takes up less space than any known comparable prior art device, and may be located anywhere desired on the substrate.

The mixer embodying the invention is a highly effective mixer implemented in suspended stripline form and characterised by its compactness and low cost. The suspended stripline mixer is compatible with planar RF circuitry, such that it can be used with RF microcircuits on quartz, gallium arsenide, or the like. The mixer makes possible the extraction of IF perpendicularly of the suspended stripline substrate, thus saving room on the substrate and minimising the number of solder connections. The mixer provides a highly advantageous manner of extracting IF, without necessitating the use of a network of capacitors, resistors and lines. The mixer is capable of being assembled by relatively unskilled labour, due to straightforward assembly techniques that the advantageous new design makes readily possible. The mixer has a circuit highly suitable for millimetre wave applications, in that it requires minimal space on suspended stripline, and can be placed at any of a number of possible locations on the substrate.

The invention will now be further described, by way of illustrative and non-limiting example, with reference to the accompanying drawings, in which:

Figure 1 is a perspective view of a typical suspended stripline rat race mixer embodying the invention, with parts of an upper housing shown removed in order to reveal some of the significant internal construction;

Figure 2 is a view of an input portion of the mixer of Figure 1, with a larger scale being used in order to reveal certain detail more clearly;

Figure 3 is an enlarged plan view of a rat race portion of the mixer, with certain call outs being utilised in order to clarify polarities, and to reveal the location where IF is extracted; and

Figure 4 is a cross-sectional view to a large scale, revealing the specific way that IF extraction preferably is accomplished.

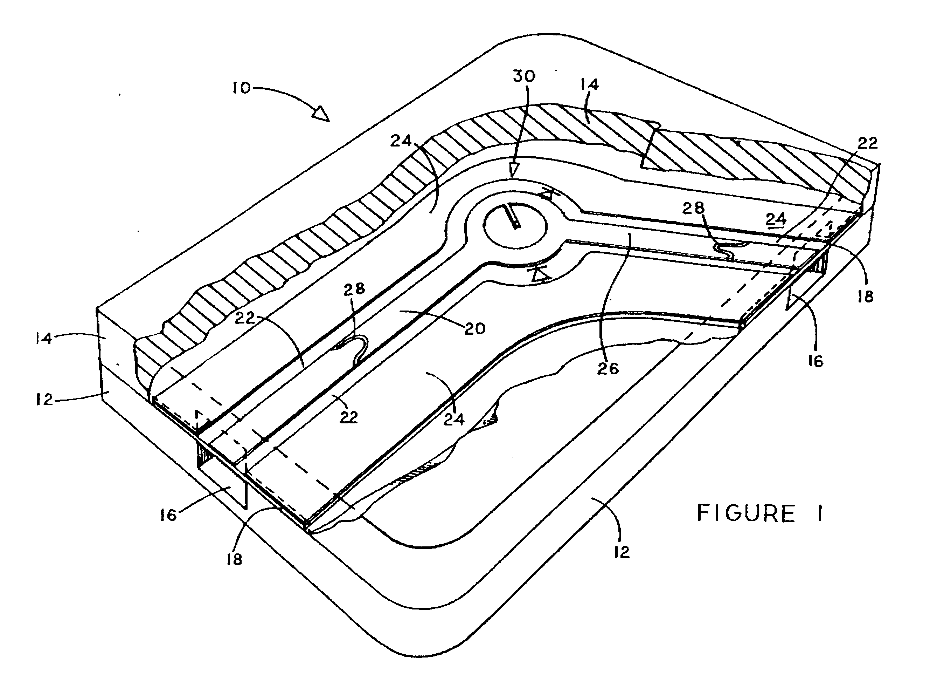

Figure 1 shows a typical section of a suspended stripline 10, involving for example a lower housing member 12 and an upper housing member 14. The housing members 12, 14 may be made of metal, and each has an identically sized rectangular cutout formed therein, such that these together form a channel 16.

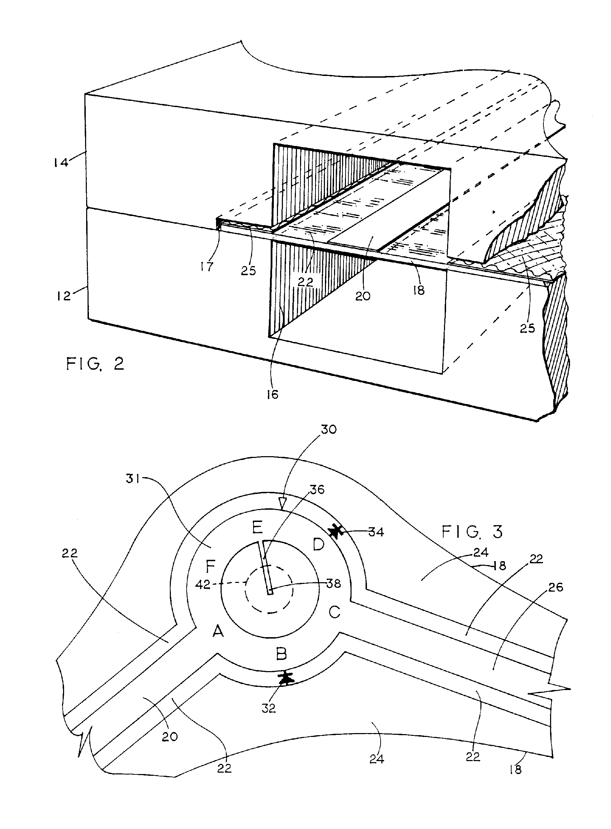

A hard dielectric member or substrate 18, such as of a size 0.254 mm (0.010 inches) thick and 3.175 mm (0.125 inches) wide, is utilised at the juncture of the two housing members 12, 14 so as to create a suspended stripline member residing at the midpoint of the channel 16; note Figure 2. The suspended stripline substrate 18 preferably is created out of quartz. The use of quartz is, however, not essential. Further, the foregoing dimensions are not essential. This type of construction used in the creation of a suspended stripline is generally old in the art.

The upper housing 14 is cut away in Figure 1 in order to reveal that conductors (conductor lines) 20 and 26 are formed along the upper surface of the hard dielectric substrate 18, preferably by the use of a very thin deposit of gold thereon, in a configuration consonant with the purpose to be served by the suspended stripline. The conductor 20 serves in this instance as a radio frequency (RF) input, whereas the conductor 26 serves in this instance as a local oscillator (LO) input. A portion 22 of clear quartz resides on the upper surface of the quartz substrate 18, on the left and right sides of the conductors 20 and 26, and in the centre of a rat race mixer or hybrid 30 described below.

A ground plane 24 is formed on the same side of the substrate 18 as the RF input line 20 and the LO input line 26, preferably by a thin deposit of gold on the surface of the substrate. It will be noted from Figures 1 and 3 that the ground plane 24 exists both on the left and on the right of the conductor lines 20 and 26, with the ground plane portions being separated from the lines 20 and 26 by the portions 22 of clear quartz, as previously mentioned. It can thus be seen from Figures 1 and 2 that the ground plane 24 entirely surrounds the rat race mixer 30 except at the input lines 20 and 26. Unlike the microstrip art where the ground plane is on the opposite side of the substrate from the conductor, in suspended stripline the ground plane 24 is created on the same side of the substrate as the conductor lines 20 and 26, as previously mentioned.

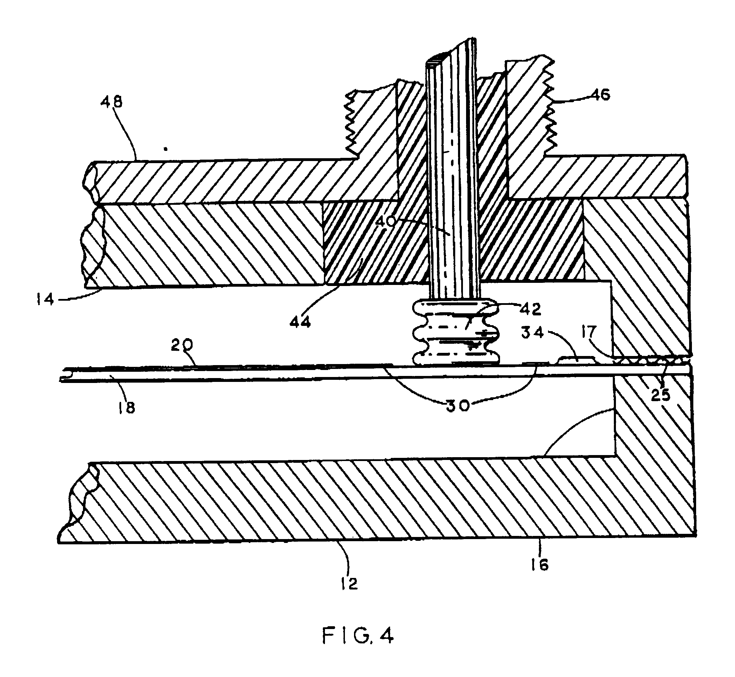

As shown in Figures 2 and 4, a thin, corrugated metal shim 25 may be attached to the ground plane portions 24 to facilitate the requisite electrical connection between the ground plane portions and the upper housing member 14, and also providing cushioning for the substrate 18 which, in the case of quartz, is very fragile.

The rat race mixer 30, as can best be seen from Figures 1 and 3, is built on the suspended stripline principle. The rat race is a 180° hybrid, consisting of 1 1/2 (one and a half) wavelengths of transmission line. If the inputs are of impedance Zo (typically 50 ohms), the ring is of impedance 2 Zo. These impedance relationships are well known in the art.

In Figure 3, points A to F on a ring portion 31 of the rat race mixer 30 will be noted to be physically 60° apart, but these points are of course 90° apart electrically. An RF signal on the conductor line 20 is fed in at the point A and travels in both directions around the ring 31. It has a maximum magnitude at the points B, D, and F, and a minimum magnitude at the points C, E, and A. These minima and maxima are caused by constructive and destructive interference of the waves travelling both in the clockwise and the anticlockwise directions around the ring 31. A local oscillator (LO) signal is fed in by the conductor line 26 at the point C, an RF minima. The local oscillator then has maxima at the points B, D, and F and minima at the points C, E, and A.

Both RF and LO present maxima at the points B, D and F, and mixer diodes may be utilised at any two of these points. In the embodiment illustrated in Figure 3, mixer diodes 32 and 34 are shown mounted at the points B and D on the ring 31. The diodes 32 and 34 are mounted on the outside of the rat race ring 31 and connected directly to IF ground, as well as RF and LO ground, with each of these grounds being regarded as existing at the ground plane 24. Both signals present minima at the inputs, providing both isolation and a good match. Whereas the prior art utilised quarter wave stubs to provide the RF and LO ground, which limited bandwidth, in the present case the diodes 32 and 34 are connected between the hybrid or ring 31 and the ground plane 24, thus providing a very satisfactory RF and LO ground that is in intimate contact with the housing members 12 and 14. The ground plane 24 also provides an excellent IF ground.

Since both high frequency signals present a minima at the point E, that is the location where it is preferred to place a thin high impedance line 36 for IF extraction in as much as this arrangement allows the least amount of RF or LO to enter the IF circuitry. The IF signal occurs on the conductor of the 180° hybrid rat race or coupler 30.

The high impedance line 36 extends to the centre point 38 of the rat race mixer 30, where a connection for IF extraction is to be made. For a 35 GHz mixer, the inner diameter of the ring 31 is about 4.19 mm ( 0.165 inches ). The impedance of the line 36 should be at least 2 Zo, or, in order words, about 100 ohms in accordance with the foregoing example.

Reference is now made to Figure 4, where a centre post 40 from a coaxial bulkhead connector, such as an SMA connector, is attached to the upper housing member 14 and extends vertically through a ring 44. The ring 44 is of polytetrafluoroethylene ("Teflon" - trade mark), although a ring of another suitable dielectric material could be substituted if preferred. Figure 4 also shows the hard dielectric substrate 18, the conductor line 20, the ring portion of the rat race coupler 30, and means providing good contact between the centre post 40 and the stripline, so as to enable the IF to be extracted in a particularly advantageous manner. A so-called "fuzzball" of metallic wire may be used for making contact between the centre post 40 and the stripline, but the use of a suitable bellows 42, as illustrated in Figure 4, is preferred for this purpose. Figure 3 illustrates by dashed lines the relationship of the bellows 42 to the high impedance line 36.

The bellows 42 is soldered to the bottom of the centre post 40, such that excellent contact is made between the centre post and the high impedance line 36 at or near the point 38 on the quartz substrate 18, due to the fact that the bellows is chosen to be of a length sufficient to form a desirable bit of pressure against the high impedance line 36. This pressure exerted by the bellows 42 does not unduly stress the quartz substrate 18 in a mechanical sense, nor does it create an undesirable electrical loading effect on the rat race.

It is to be realised that the above-described IF extraction arrangement advantageously requires no solder connection to the substrate, and the connection may be repeatedly assembled and disassembled without damage to any of these components. It also should be noted to permit assembly of devices embodying the invention without necessitating the use of skilled labour. This of course follows from the straightforward assembly techniques that the design make possible.

By way of example, bellows of 0.94 mm (0.037 inches) diameter are quite satisfactory, and they are commercially available.

As shown in Figure 4, screw threads 46 on an upper metal member 48 are designed to receive a coaxial connector, such as a type SMA connector. These threads 46 may be regarded as ground.

As should now be clear to those skilled in the art, there has been described above a highly advantageous rat race mixer having a ring 31 that is entirely surrounded by a ground plane 24, with the RF and LO relationships being such that the ring is at RF and LO potential. After accomplishing this, it then became necessary to make the surrounding ground plane also the ground for the IF, and at the same time to be able to accomplish the extraction of the IF. This was accomplished by placing the high impedance line 36 at the point E on the ring 31 of the rat race, an RF and LO minima, with the bellows arrangement 42 preferably being used to extract the IF, as previously mentioned. By the use of the SMA connector, the IF is directed through the coaxial connector (received on the threads 46) to a preamplifier of a mixer or other IF circuitry.

It is apparent that the conductor lines 20 and 26 of the rat race must not be shorted to ground in any circuit in which a mixer is used. Use is therefore made of a DC block or coupling capacitor in the LO and RF conductor lines 26 and 20 as required, such as shown at 28 in two locations in Figure 1.

In the above-described mixer, the rat race is at RF, LO and IF potential, and the ground plane 24 is ground for all three signals. This is in distinct contrast to the teachings of the prior art, where the rat race is typically at IF ground, and at RF and LO potential. This had the disadvantage of requiring quarter wave stubs or holes with grounding wires extending through the substrate to provide RF/LO ground. Since the stubs necessarily are at IF potential, the IF needed to be extracted from each stub and then recombined, typically by the use of jumper wires. This not only is more complicated than the present design, but also usually placed a distinct limit on operating bandwidth.

By now it should be quite apparent that no quarter wave stubs are needed in the above-described mixer for RF or LO ground; that no holes through the substrate are necessary for IF ground; nor are any jumper wires needed for IF removal. Became of its compactness and low cost, the above-described mixer is entirely suitable for a wide range of applications.

## Claims

1. A suspended stripline rat race mixer (30) comprising:

a ring (31) connected to a radio frequency (RF) input line (20) and a local oscillator (LO) input line (26) each extending radially outwardly of the ring, the ring (31) and the input lines (20, 26) being formed by a conductive layer on one surface of a dielectric substrate (18);

diode means (32, 34) connecting an outer part of the ring (3) to ground at locations of RF and LO maxima; and

extracting means for extracting an intermediate frequency (IF) signal generated in the ring;

characterised in that the diode means (32, 34) connects the ring (3) to a ground plane (24) formed by a conductive layer on said surface of the substrate (18), in that the ground plane (24) surrounds the ring (31) entirely except at the input lines (20, 26), and in that the extracting means is provided at the centre of the ring (31).

2. A mixer according to claim 1, including a high impedance lead (36) extending from the ring (31) to the centre of the ring and defining the location at which in use the IF signal is extracted.

3. A mixer according to claim 2, in which a bellows (42) is in contact with the high impedance lead (36), the bellows being supported by a centre post (40) of a coaxial bulkhead connector, by which in use the IF signal is extracted.

4. A mixer according to claim 2, in which a fuzzball is in contact with the high impedance lead (36), the fuzzball being supported by a centre post (40) of a coaxial bulkhead connector, by which in use the IF signal is extracted.

5. A mixer according to any one of the preceding claims, in which the ground plane (24) surrounding the ring (31) is ground for all signals present in use in the mixer, that is for IF, RF, and LO.

**Patentansprüche**

1. Hybridringmischer (30) in der an Zwischenwänden gehalterten Streifenleitungstechnik, wobei der Mischer aufweist:

einen Ring (31), der mit einer Eingangsleitung (30) für Radiofrequenz (RF) und einer Eingangsleitung (26) für einen lokalen Oszillator (LO) verbunden ist, die sich jeweils in radialer Richtung von außen von dem Ring erstrecken, wobei der Ring (31) und die Eingangsleitungen (20, 26) aus einer leitfähigen Schicht auf einer Oberfläche auf einem dielektrischen Substrat (18) gebildet werden,

Diodeneinrichtungen (32, 34), welche einen äußeren Teil des Ringes (3) an Positionen von RF- und LO-Maxima mit Masse verbinden, und

einer Ableitungs- bzw. Auskoppeleinrichtung für das Ableiten eines Zwischenheguenz-(IF) -Signals, welches in dem Ring erzeugt wird, dadurch gekennzeichnet, daß die Diodeneinrichtungen (32, 34) den Ring (3) mit einer Massenebene (24) verbinden, die von einer leitfähigen Schicht auf der Oberfläche des Substrates (18) gebildet wird, daß die Massenebene (24) den Ring (31) vollständig umgibt mit Ausnahme an der stelle der Eingangsleitungen (20, 26) und daß die Ableitungseinrichtung im Zentrum des Ringes (31 ) vorgesehen ist.

2. Mischer nach Anspruch 1, einschließlich einer Hochimpedanzleitung (36), welche sich von dem Ring (31) zum Zentrum des Ringes erstreckt und die Stelle definiert, an welcher das IF-Signal im Gebrauch abgeleitet wird.

3. Mischer nach Anspruch 2, bei welchem ein Balg (42) in Kontakt mit der Hochimpedanzleitung (36) steht, der Balg von einem zentralen Stift (40) eines koaxialen Trennwandanschlusses gehaltert wird, durch welchen im Gebrauch das IF-Signal abgeleitet wird.

4. Mischer nach Anspruch 2, bei welchem ein Knäuel in Kontakt mit der Hochimpedanzleitung (36) steht, wobei das Knäuel von einem zentralen Stift (40) eines koaxialen Trennwandanschlusses gehaltert wird, durch welchen im Gebrauch das IF-Signal abgeleitet wird.

5. Mischer nach einem der vorstehenden Ansprüche, bei welchem die Massenebene (24), welche den Ring (31 ) umgibt, Masse für alle im Gebrauch des Mischers vorhandenen Signale ist, d.h. für die IF, RF und die LO (-Frequenzen).

**Revendications**

1- Mélangeur dérivateur à ligne de bande suspendue comprenant :

un anneau (31) connecté à une ligne d'entrée (20) de la fréquence radio (FR) et une ligne d'entrée (26) de l'oscillateur local (OL), dont chacune s'étend radialement vers l'extérieur de l'anneau, l'anneau (31) et les lignes d'entrée (20,26) étant formés par une couche conductrice sur une face d'un substrat diélectrique (18) ;

des moyens du type diode (32,34) qui connectent une partie extérieure de l'anneau (3) à la masse aux emplacements des maxima de FR et de OL ; et

des moyens d'extraction servant à extraire un signal de fréquence intermédiaire (FI) engendré dans l'anneau ;

caractérisé en ce que les moyens du type diode (32,34) connectent l'anneau (3) à un plan de masse (24) formé par une couche conductrice sur ladite surface du substrat (18), en ce que le plan de masse (24) entoure entièrement l'anneau (31), sauf aux lignes d'entrée (20,26), et en ce que les moyens d'extraction sont prévus au centre de l'anneau (31).

2- Mélangeur selon la revendication 1, comprenant un conducteur de haute impédance (36) qui s'étend de l'anneau (31) au centre de l'anneau et qui définit le point où le signal FI est extrait en utilisation.

3- Mélangeur selon la revendication 2, dans lequel un soufflet (42) est en contact avec le conducteur de haute impédance (36), le soufflet étant supporté par une tige centrale (40) d'un connecteur de traversée coaxial par lequel le signal FI est extrait en utilisation.

4- Mélangeur selon la revendication 2, dans lequel un fil dit "vesse de loup" ("fuzzball") est en contact avec le conducteur à haute impédance (36), la vesse de loup étant supportée par une tige centrale (40) d'un connecteur coaxial à cloison étanche par lequel le signal FI est extrait en utilisation.

5- Mélangeur selon une quelconque des revendications précédentes, dans lequel le plan de masse (24) qui entoure l'anneau (31) est la masse pour tous les signaux présents dans le mélangeur en utilisation, c'est-à-dire pour FI, FR et OL.

FIGURE 1

FIG. 2

FIG. 3

FIG. 4